# EUROPEAN PATENT APPLICATION

(11) **EP 3 772 086 A1**
(43) Date of publication of application: **03.02.2021**
(21) Application number: 19382668.2
(22) Date of filing: 01.08.2019
(51) Int. Cl.: H01L 21/02, H01G 11/32, H01L 21/268

(54) **METHOD TO FORM A LASER-SCRIBED RGO PATTERN ON A SUBSTRATE**

(71) Applicant: Fundació Institut Català de Nanociència i Nanotecnologia (ICN2), 08193 Bellaterra (ES)
(72) Inventor: SENA -TORRALBA, Amadeo, 46970 ALAQUÀS (ES); RAULIECIVH ALVAREZ, Ruslan, 08031 BARCELONA (ES); MERKOÇI HYKA, Arben, 08290 CERDANYOLA DEL VALLÈS (ES)
(74) Representative: ZBM Patents - Zea, Barlocci & Markvardsen

(57) **Abstract**

It is provided a method of forming an electronic device on a substrate, particularly a flexible substrate, comprising filtering a graphene oxide (GO) aqueous suspension through a porous membrane in order to obtain a GO film; laser scribing a specific design on the GO film in order to form a reduced graphene oxide (rGO) pattern on the GO film; and pressing the substrate against the rGO pattern on the GO film in order to transfer the rGO pattern to the substrate to form the electronic device thereon. It is also provided an electronic device on a substrate obtainable by the method as defined above and an apparatus comprising the electronic device on a substrate.

## Description

### Technical Field

The present invention is related to the field of electronic devices. Particularly, it relates to a method of forming an electronic device on a suitable substrate, to the electronic device itself and to an apparatus comprising it. Such a device may be, for example, an electrode or an electrode array or, more generally, an electronic platform.

### Background Art

Printed technologies are nowadays transforming the field of sensors and electronics due to the implementation of new emerging materials and the constant development of patterning techniques; offering the possibility to produce ubiquitous flexible, cost effective and ease of manufacturing devices.

High resolution printed inks on plastic or paper substrates are one of the most promising solutions for this purpose since they allow the development of large-area and low-cost flexible electronics. Although a wide variety of materials can be used, carbon-based inks have proven to be excellent candidates.

Among carbon-based materials, graphene (intended as a single monolayer of carbon atoms tightly packed into a honeycomb lattice) is very well known for its high electrical conductivity, mechanical flexibility and strength, optical transparency, chemical stability and biocompatibility.

Graphene oxide (GO), a graphene precursor which consists of a stable aqueous dispersion of a single layer of graphite oxide, can be transformed into conductive reduced graphene oxide (rGO) through chemical, thermal, photo-reduction processes, among others. rGO-based electronics can be considered as a good replacement of both rigid silicon electronics and expensive pristine graphene exhibiting most of the properties required in sensing and electronic applications.

Depending on the final application, rGO can be obtained in aqueous dispersion, powdered or directly reduced on the specific substrate. In order to produce printed circuits, it is necessary to use the rGO in the form of an ink adding different solvents that may affect the substrate. Besides, photolithography and screen-printing techniques require the use of pre-defined masks that increase the cost of the product and limit any further changes in the design. Additionally, for integrating conductive rGO-based materials with transparent substrates, a transfer step is indispensable. This step usually involves the use of solvents and a chemical pre-treatment of the substrates in order to improve the adhesion and assure a successful transfer.

Document WO2015193486A1 discloses a method for forming an electronic device on a flexible substrate comprising printing a hydrophobic mask on a porous membrane to form a pattern thereon which is complementary to a desired pattern; filtering an aqueous suspension of graphene oxide (GO) through the non-printed region of the porous membrane, whereby some electronic material is deposited on said non-printed region following the desired pattern; pressing the flexible substrate against the printed face of the membrane in order to transfer the patterned GO deposited on the porous membrane to the flexible substrate to form the electronic device thereon. As an option, the pattern of GO can be reduced with hydrazine vapour to obtain a pattern of reduced graphene oxide (rGO).

Document WO2012128748 discloses a method to form a pattern on a graphite oxide membrane to produce a patterned graphite oxide membrane. The pattern is formed by reducing a portion of the graphite-oxide membrane to conducting reduced graphite oxide. The patterned graphite oxide membrane can be used to form a device by cutting a pattern from tape and affixing the tape to the patterned graphite oxide membrane as such.

Therefore, there is a need of an improved technology that allows producing highly conductive rGO patterns on flexible substrates with low-cost and large-scale production processes and with high reliability, while avoiding the use of solvent and reducing chemicals, which might damage the substrates.

### Summary of Invention

The present inventors, in an attempt for developing an improved technology to produce electronic materials onto flexible substrates, have carried out a rapid and extremely low-cost method for the production of highly conductive laser-scribed rGO thin films on a substrate, particularly on a flexible substrate. This methodology consists of three main steps, involving vacuum filtering of a GO aqueous suspension through a porous membrane such as a nitrocellulose membrane, reduction of the GO surface using a laser, and solvent-free transfer of the resulting rGO pattern onto new substrates via pressure-based mechanism.

Thus, in a first aspect the present invention relates to a method of forming an electronic device on a substrate, the method comprising the steps of:
a) filtering a graphene oxide (GO) aqueous suspension through a porous membrane in order to obtain a GO film,
b) laser scribing a specific design on the GO film in order to form a reduced graphene oxide (rGO) pattern on the GO film;
c) pressing the substrate against the rGO pattern on the GO film in order to transfer the rGO pattern to the substrate to form the electronic device thereon.

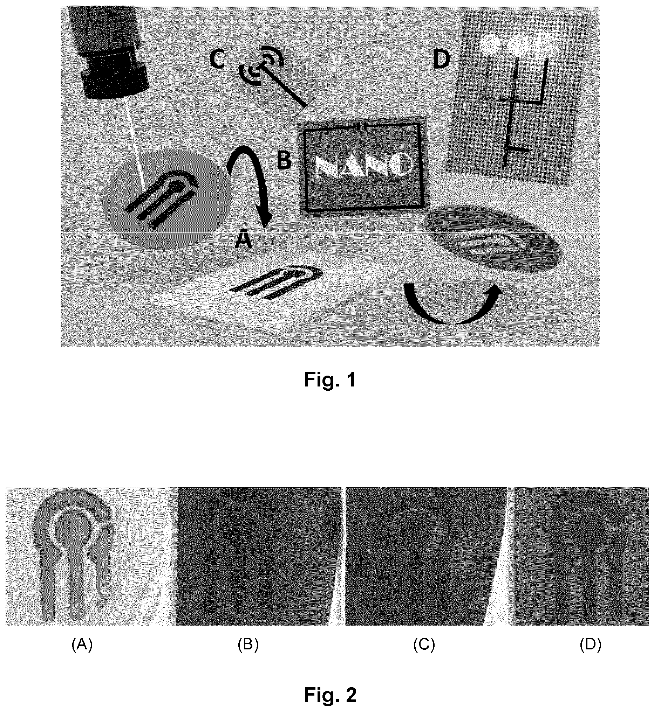

The process allows overcoming the limitations of the processes of the prior art by direct patterning and rGO transfer to almost any substrate. A specific design can be laser-scribed on a nitrocellulose membrane containing a uniform layer of graphene oxide and only the reduced part be transferred (see Fig. 1). Advantageously, neither a predefined mask to form the desired pattern nor any treatment of the substrate, such as for transferring the pattern to the final substrate (being a dry transfer, the final substrate is not affected by any solvent) or for the reduction of the GO pattern, are needed.

In a second aspect, the present invention relates to an electronic device on a substrate obtainable by the process as defined herein above and below.

In a third aspect, the present invention relates to an apparatus comprising an electronic device on a substrate as defined herein above and below.

### Brief Description of Drawings

Fig. 1 shows a scheme of the technique and developed devices. A design is laser-scribed on a nitrocellulose membrane containing a uniform layer of graphene oxide. The laser-scribed rGO pattern is transferred onto a substrate leaving the remains of GO in the membrane. Examples of the stamping process onto different materials: (A) Paper based electrode, (B) Electroluminescent lamp, (C) Proximity and touch sensor on PET, (D) 3D circuits on fabric.
Fig. 2 shows some examples of rGO patterns on membranes for different GO concentrations: (A) 0.1 mg/mL GO in 10 mL aqueous suspension; (B) 0.4 mg/mL GO in 10 mL aqueous suspension; (C) 0.6 mg/mL GO in 10 mL aqueous suspension; (D) 0.8 mg/mL GO in 10 mL aqueous suspension.
Fig. 3 shows the high-resolution scanning electron microscopy (SEM) images of the rGO/GO surface on membranes five times reduced ((A) 0.1 mg/mL 10 mL, (B) 0.4 mg/mL 5 mL). Lower volumes and higher concentrations of GO aqueous suspension show a more uniform surface.
Fig. 4 shows the high-resolution SEM images of GO 0.4 mg/mL 5 mL on membranes, with different reduction steps ((A) 2 reduction steps, (B) five reduction steps): the surface results flatter and more evenly reduced as the number of reduction steps increases.
Fig. 5 shows the SEM images of films formed on nitrocellulose paper with different GO concentrations ((A) 0.01 mg/mL 5 mL, (B) 0.6 mg/mL 5 mL, (C) 1.0 mg/mL 5 mL), five reduction steps.
Fig. 6 shows the SEM images of rGO 0.1 mg/mL 5 mL (A) on ITO and (B) on silicon.
Fig. 7 shows the AFM images of rGO flakes on silicon substrates.
Fig. 8 shows the sheet resistance for different concentration of GO in both 5 and 10 mL aqueous suspensions, from two to five times reduced.
Fig. 9 shows the conductivity map (contour map) for different reduction steps and several concentrations of GO in 5 mL volume aqueous suspension.
Fig. 10 shows the sheet resistance behavior for a concentration of GO of 0.4 mg/mL 5 mL depending on number of reduction steps (n); sd = standard deviation, n = number of reduction steps, SR = sheet resistance.
Fig. 11 shows the surface characterization of GO 0.4 mg/mL in 5 mL and rGO for different reduction degrees. (A) Raman spectra. (B) EDX results. (C) XPS analysis.
Fig. 12 shows the results of a bending test. SR = sheet resistance.
FIG. 13 shows (A) CV at 50 (mV/s) of the rGO electrodes and C-SPE in the presence of 3 mM [Ru(NH₃)₆]Cl₃. (B) SEM image of the rGO electrode on nitrocellulose paper. (C) Image of the transferred rGO electrodes on nitrocellulose (upper panel) and PET (bottom panel). (D) DPV of the rGO electrodes and C-SPE in the presence of 10⁻⁴ M of dopamine.

### Detailed description of the invention

For the sake of understanding, the following definitions are included and expected to be applied throughout the description, claims and drawings.

The term "room temperature" refers to a temperature from about 20 °C to 25 °C.

As used herein, the indefinite articles "a" and "an" are synonymous with "at least one" or "one or more". Unless indicated otherwise, definite articles used herein, such as "the", also include the plural of the noun.

As mentioned above, a first aspect relates to a method of forming an electronic device on a substrate, which is an isolated rGO film on a substrate, comprising filtering a graphene oxide (GO) aqueous suspension through a porous membrane in order to obtain a GO film; laser scribing a specific design on the GO film in order to form a reduced graphene oxide (rGO) pattern on the GO film; and pressing the substrate against the rGO pattern on the GO film in order to transfer the rGO pattern to the substrate to form the isolated rGO film thereon. Consequently, the final transferred rGO exhibits an inverted structure with respect to the original pattern.

By filtering the GO aqueous suspension through a porous membrane, a uniform and reproducible GO film is obtained. After the filtering, the GO mesh is strongly attached to the membrane surface. Conversely, once the membrane is dried, the rGO pattern obtained by laser scribing is easily removable, in particular the more superficial layers which are reduced several times. Moreover, the superficial layers, reduced several times, show lower electrical resistance than the underlying layers.

Thus, in the transfer step only the reduced pattern is transferred on the new substrate while the GO mesh remains attached to the membrane. This is an advantage since, although GO is a non-conductive material, it can undergo a progressive reduction over time under certain conditions (depending on the temperature and humidity) and as a consequence the GO film tends to shrink and become conductive. Thus, the electronic device on a substrate of the present disclosure avoids problems such as interferences derived from the reduction with time of the non-reduced GO.

The porous membrane can be made of nitrocellulose, but other materials such as PTFE and paper can be used. In one embodiment, the porous membrane is made of nitrocellulose. The characteristics of the surface of nitrocellulose membranes (smooth and hydrophobic) allows that the transfer can easily take place.

In another embodiment, the porous membrane has a pore size from 0.01 µm to 0.3 µm, particularly from 0.015 µm to 0.1 µm, and even more particularly from 0.02 µm to 0.03 µm. Depending on the pore size of the filter, various nanomaterials can be filtered and be integrated in the film.

By varying the volume and concentration of the GO aqueous suspension used to form the GO film (both determining the thickness of the GO film), the degree of reduction to form the rGO pattern (i.e. times that laser scribing is performed with a given laser power), and the pressure of the transfer step, the thickness and conductivity of the final rGO pattern can be controlled in order to achieve thin and highly conductive films.

Thus, in an embodiment, optionally in combination with one or more features of the particular embodiments defined above, the amount of GO per unit area is from 0.04 mg/cm² to 0.32 mg/cm², particularly from 0.12 mg/cm² to 0.28 mg/cm², more particularly of 0.16 mg/cm². Thus, in another embodiment, optionally in combination with one or more features of the particular embodiments defined above, the thickness of the GO film is from 200 microns to 1,5 mm.

For such amount of GO, the conductivity of the material increases with the number of reduction steps until the degree of reduction reached a threshold value. In order to achieve the desired degree of reduction, the laser power can be from 5 mW to 20 W depending on the laser scribing speed and the laser beam width.

The comparison of the carbon to oxygen (C/O) ratios between graphite oxide (GO) and reduced laser scribed graphene (rGO) provides an effective measurement of the extent of reduction achieved using an infrared laser. Prior to laser reduction, typical GO films have a C/O ratio of approximately 2.6, corresponding to a carbon/oxygen content of 72% and 38%, respectively. On the other hand, rGO has an enhanced carbon content of 96.5% and a diminished oxygen content of 3.5%, giving an overall C/O ratio of 27.8.

Thus, in another embodiment, optionally in combination with one or more features of the particular embodiments defined above, the laser scribing step (in order to reduce GO) is performed until the rGO has a carbon content from 75% to 96.5% and a oxygen content from 25 % to 3.5%, particularly a carbon content from 86% to 95% and a oxygen content from 14 % to 5%, more particularly a carbon content of 96.5% and an oxygen content of 3.5%.

Additionally, depending on the affinity of the target substrate, the pressure exerted may vary. The fact of applying more or less pressure makes it possible to transfer it to almost any substrate. Thus, in another embodiment, optionally in combination with one or more features of the particular embodiments defined above, the transfer step is performed with a press that exerts a pressure from 0.4 kg/cm² to 300 kg/cm², particularly of 230 kg/cm². The transfer of the rGO pattern onto the target substrate can be performed by means of, for instance, vertical pressure or roll-to-roll-like pressure.

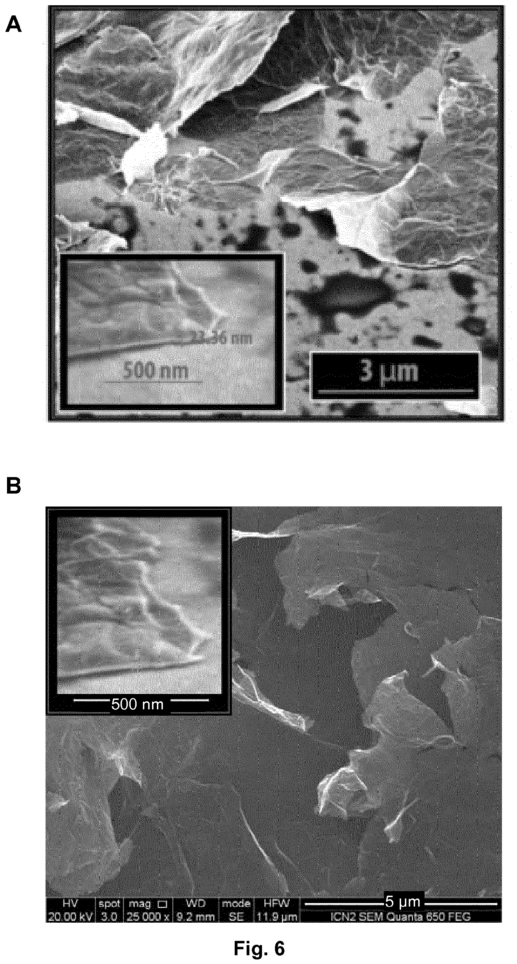

The layer of the transferred rGO is composed of overlapping flakes that can form several layers. Each flake is about hundreds of microns in lateral size, such as from 200 µm to 800 µm, and about 20 nm to 30 nm thick (Figure 6). The whole thickness can cover a range from 30 nm to 600 µm depending on the substrate used and the GO concentration.

Thus, in another embodiment, optionally in combination with one or more features of the particular embodiments defined above, the transferred rGO pattern has a thickness from 30 nm to 1000 nm, particularly from 40 nm to 600 nm. In another embodiment, optionally in combination with one or more features of the particular embodiments defined above, the transferred rGO pattern has a resistivity from 100 Ω/sq to 2000 Ω/sq at room temperature, particularly from 200 Ω/sq to 700 Ω/sq. As an instance, the process allows forming isolated rGO patterns with a resistivity of 200 Ω/sq at room temperature. The transfer of the rGO pattern by pressing it against the target substrate leads to an improvement of the conductivity of the material due to a better integration of the rGO layers (decreases the separation between layers).

Examples of materials that can be used as substrates include silicon wafer, indium tin oxide (ITO), aluminum foil, glass, polydimethylsiloxane (PDMS), poly(ethylene terephthalate) (PET); paper such as office paper, photographic paper, nitrocellulose paper, and filter paper; plaster; skin; and diverse types of textile. These materials are useful for nanoelectronics applications, wearable sensing and electrochemistry.

In an embodiment, optionally in combination with one or more features of the particular embodiments defined above, the substrate is a flexible substrate. Thus, particularly, the flexible substrate is selected from the group consisting of aluminum foil, polydimethylsiloxane (PDMS), poly(ethylene terephthalate) (PET); paper; skin; and diverse types of textile.

Additionally, depending on the application, multiple rGO patterns can be transferred one on top of another forming several lines (i.e. conductive bands), what allows obtaining 3D circuits. Thus, in another embodiment, optionally in combination with one or more features of the particular embodiments defined above, steps a), b) and c) can be repeated in order to form at least two overlaid lines of rGO. In a particular embodiment, a layer of dielectric paste or of capacitive is applied between each two consecutive lines of rGO.

As mentioned above, an electronic device on a substrate obtainable by the process as defined herein above also forms part of the invention. All particular embodiments of the process are also particular embodiments of the cathode obtainable by said process.

As mentioned above, the electronic device on a substrate, particularly a flexible substrate, is characterized by comprising an isolated rGO film having a thickness from 30 nm to 1000 nm, and particularly, a resistivity from 100 Ω/sq to 2000 Ω/sq at room temperature.

The electronic device on a substrate of the present disclosure is useful in sensing and electronic applications.

In an embodiment, the electronic device on a substrate is an electroanalytical sensor. In another embodiment, the electronic device on a substrate is a proximity and touch sensor. In another embodiment, the electronic device on a substrate is an electronic tattoo sensor on the skin.

The method allows for great versatility and, for instance, the electronic device on a substrate may be an interdigitated electrode, circular or otherwise, or an electrode microarray.

In an embodiment, the electroanalytical sensor is a one-step electrochemical biosensor. One-step electrochemical biosensors can be obtained by depositing the required antibody or aptamer on the rGO transferred rGO pattern in order to capture the analyte of interest. This allows replacing optical (visual) detection by electrochemical detection, what would considerably increase the sensitivity by several orders of magnitude.

In another embodiment, the electroanalytical sensor is an electrochemical lateral flow sensor. This can be obtained by transferring 2 or 3 electrodes in a lateral flow strip. The desired antibody would be printed on a test line above or below a working electrode. A counter electrode and, optionally, a reference electrode would also be transferred to the substrate. The system allows electrochemical measurements (amperometry, cyclic voltammetry, differential pulse voltammetry). In a particular embodiment, the substrate of the electrochemical lateral flow sensor is a nitrocellulose paper. Advantageously, the method of the present disclosure allows obtaining the electrochemical lateral flow sensor without damaging the nitrocellulose substrate.

Other possible applications of the electronic device on a substrate of the present disclosure include electroluminescent lamp components, and circuits on fabric.

The present disclosure also contemplates an apparatus comprising an electronic device on a substrate made with the above-disclosed method.

Throughout the description and claims the word "comprise" and variations of the word, are not intended to exclude other technical features, additives, components, or steps. Furthermore, the word "comprise" encompasses the case of "consisting of". Additional objects, advantages and features of the invention will become apparent to those skilled in the art upon examination of the description or may be learned by practice of the invention. The following examples and drawings are provided by way of illustration, and they are not intended to be limiting of the present invention. Furthermore, the present invention covers all possible combinations of particular and preferred embodiments described herein.

### Examples

The materials were characterized in terms of their surface, electrical and electrochemical properties.

### Surface Characterization:

For the surface characterization, Magellan 400L XHR SEM (FEI, Hillsboro, OR) and Quanta 650FEG ESEM (FEI, Hillsboro, OR) were used to performed SEM and EDX analysis, while the film thickness was measured with a profilometer (Alpha Step D-500 Stylus Profiler, KLA-Tencor) and Asylum MFP-3D Atomic Force Microscope.

The reduction efficiency was assessed via XPS measurements, using a Phoibos 150 hemispherical energy analyzer (SPECS GmbH, Berlin, Germany), and confocal Raman spectrometer equipped with a 488 nm laser, with 1.5 mW power, grating 600 gr/nm and objective 50x. Every single spectrum was collected for 10s and 3 accumulations.

### Electrical Characterization:

A study of the conductivity depending on GO concentration and reduction degree was made via four-point-probe method using Keithley 2400 SourceMeter SMU Instruments. Contact resistance measurements were made in presence of silver ink (C2100203D2) from Gwent group/Sun Chemical (Pontypool, U.K.).

### Electrochemical Characterization:

All the electrochemical measurements were performed using an AutoLab PGStat302 connected to a computer equipped with the software NOVA 2.1.3 (Metrohm AutoLab).

The electrodes were electrochemically characterized by means of cyclic voltammetry (CV) in presence of [Ru(NH₃)₆]Cl₃ (Sigma Aldrich) as redox probe, in a 0.01 M phosphate buffer saline solution (PBS) as supporting electrolyte, prepared starting from pallets (Sigma Aldrich) dissolved in MilliQ water (Purelab Option-Q). CV was performed in a potential range between -0.8 V and +0.5 V (Ag) and the scan rate was varied between 10 mV s⁻¹ and 750 mV s⁻¹.

As proof of concept, the electrodes were used to detect dopamine hydrochloride (Sigma Aldrich) in a concentration of 10⁻⁴ M, prepared in PBS, using differential pulse voltammetry (DPV) as electroanalytical technique. The potential was scanned between -0.2 and +0.6 V (Ag) with a pulse of 5 mV and an amplitude of 50 mV.

### Example 1. Graphene Oxide electronic device

### Filtering, Reduction and Transfer:

Graphene oxide ink was taken from Angstrom Materials, solution N002-PS-1.0, 10 mg/mL. All the aqueous suspensions were prepared with Milli-Q water (Purelab Option-Q). The hydrophilic membranes (nitrocellulose filter membranes) used had a pore size of 0.025 µm and 47 mm of diameter.

Aqueous suspensions at various concentrations were filtered through the membranes using a 1 L vacuum-filtering flask, 300 mL glass filter holder and 47 mm SS screen (1/Pk).

The reduction process was made using a LightScribe DVD burner enabled with lightscribe technology. The reduced pattern was transferred on new substrates using a press at 12 KPa. The new substrates were subjected to plasma cleaning in a Harrick Plasma.

LightScribe is a commercially available program that is used in conjunction with a DVD optical drive unit to pattern images on any LightScribe-enabled CD/DVD disk. The program controls the 788 nm infrared laser (maximum power output = 5 mW) inside an optical drive unit by periodically pulsing an objective lens assembly, causing the laser to focus and defocus on an infrared active dye matrix found on the top side of a LightScribe-enabled CD/DVD disk (cf. V. Strong, et al. "Patterning and Electronic Tuning of Laser Scribed Graphene for Flexible All-Carbon Devices", ACS Nano, 2012, Vol. 6, pp. 1395-1403).

### Example 2. Electrodes Preparation

First, electrodes were prepared by filtering GO aqueous suspension of 0.4 mg/mL in a total volume of 5 ml. Five reduction steps were chosen as the best parameters. The stamping procedure was performed and the final design was transferred on two different substrates: poly(ethylene terephthalate) (PET) film and nitrocellulose paper (8 µm, CNPF-SN12, 25 mm, ADVANCED MICRODEVICES PVT. LTD.). Silver paste (C2100203D2) from Gwent group/Sun Chemical (Pontypool, U.K.) was used to make electric contact and a layer of grey dielectric paste (D2070423P5) from Gwent group/Sun Chemical (Pontypool, U.K.) was printed in order to insulate the working part avoiding contacts between the solution and the electric component.

A similar procedure was carried out for several concentrations and volumes of graphene oxide (GO) aqueous suspensions (Table 1), which were filtered through 0.25 µm porous membranes.

**Table 1. Combinations of GO concentration used**

| 5 mL aqueous suspension | 10 mL aqueous suspension |
|---|---|
| - | 0.01 mg/mL GO |
| 0.1 mg/mL GO | 0.1 mg/mL GO |
| 0.2 mg/mL GO | 0.2 mg/mL GO |
| 0.4 mg/mL GO | 0.4 mg/mL GO |
| 0.5 mg/mL GO | 0.5 mg/mL GO |
| 0.6 mg/mL GO | 0.6 mg/mL GO |
| 0.8 mg/mL GO | 0.8 mg/mL GO |
| 1.0 mg/mL GO | 1.0 mg/mL GO |

The process required from 5 to 40 minutes as concentrations and volumes increased. After the filtering, the GO mesh was strongly attached to the membrane surface preventing the transfer of the entire film, unless specific treatments were made. Once the membrane was dried, the GO was laser-scribed with the DVD-burner laser resulting in a reduced graphene oxide (rGO) pattern. Fig. 2 shows several rGO patterns on membranes for different GO concentrations. The areas with reduced surfaces were clearly delimited by a colour change (from brown to dark) and were easily removable, in particular the more superficial layers which were reduced several times. In this way, only the reduced patterns were transferred on new substrates separating them from the GO mesh which remained attached to the membrane. Moreover, the superficial layers, reduced several times, showed lower resistance than the underlying levels.

The GO concentration, reduction and transfer processes were optimized in order to obtain a high thickness control and to ensure the transfer of only the outermost rGO layers achieving thin and highly conductive films.

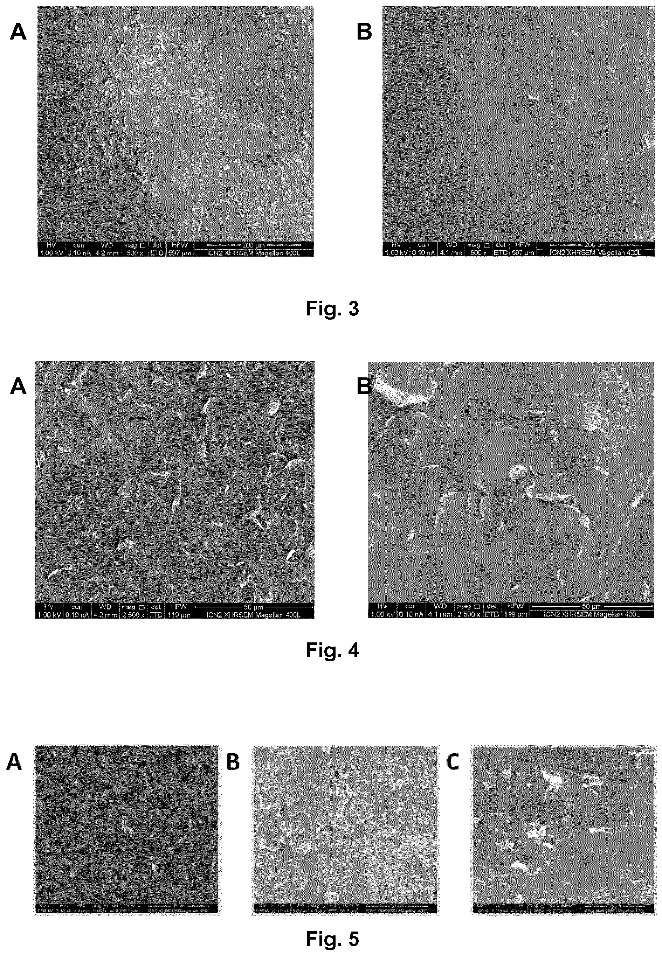

High-resolution scanning electron microscopy (SEM) images of the rGO/GO surface on membranes showed a more uniform reduction and a more constant thickness for higher concentrations and volumes of the GO aqueous suspension (Fig. 3). Samples that were reduced five times show a more uniform surface (Fig. 4).

### Example 3. Characterization

In order to assess the suitability of the electronic devices of the present disclosure in nanoelectronics and sensing applications, an extensive characterization of the material was made in terms of surface study, conductivity and electrochemical properties, what allowed optimizing all the parameters.

### Surface morphology

The surface morphology of rGO formed using different concentrations and reductions steps and transferred on several substrates was investigated. It was verified that the layer of rGO formed was composed of overlapping flakes. As an instance, they were well recognizable using low concentrations of a GO aqueous suspension and very smooth and flat substrates, such as silicon or ITO. For higher concentrations of the GO aqueous suspension a better transfer and a more uniform covering of the surface was observed (Fig. 5). An analysis of the rGO conductivity revealed lower values of sheet resistances for lower volumes and concentrations of the GO aqueous suspension and using five reduction steps.

In light of these results, it is necessary to find out the right compromise between a good surface coverage (which will also depend on the target substrate), while keeping the rGO film as thin as possible (to achieve high conductivity).

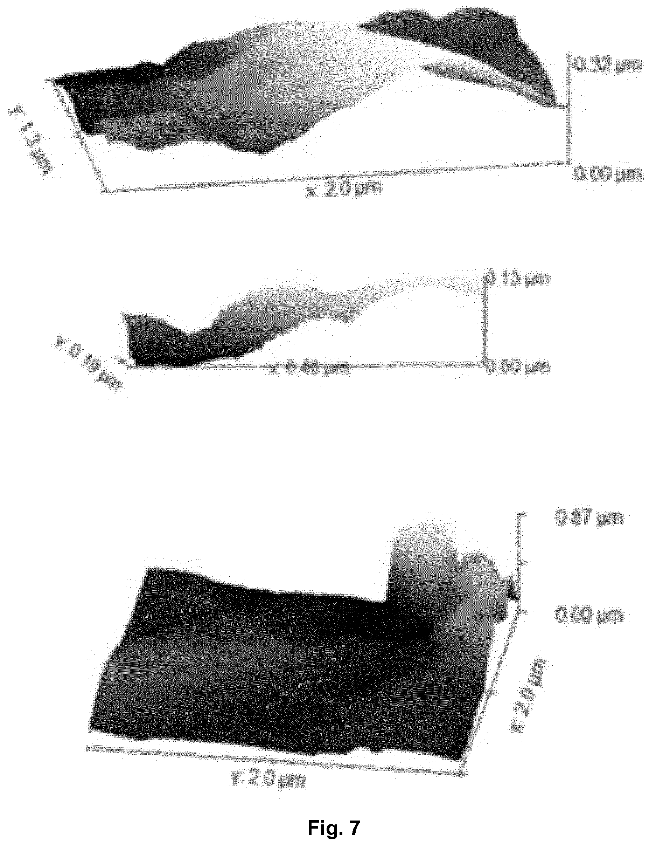

SEM and AFM analysis confirmed that the rGO surface was composed of overlapping flakes of a few nanometers thick. The whole thickness covered a range from hundreds of nanometers to microns depending on the substrate used and the GO concentration. Each flake was about hundreds of microns in lateral size, and about 20 to 30 nm thick. As can be seen in Fig. 6 ((A) SEM images of rGO 0.1 mg/mL 5 mL on ITO; (B) SEM images of rGO 0.1 mg/mL 5 mL on silicon), the low concentration and the conductive surface of ITO allow to isolate single flake layers of rGO. Similarly, as shown in Fig. 7 (AFM images of rGO flakes on silicon substrates), the rGO is not uniformly attached to the substrate, and not adhered flakes are clearly visible.

### Conductivity

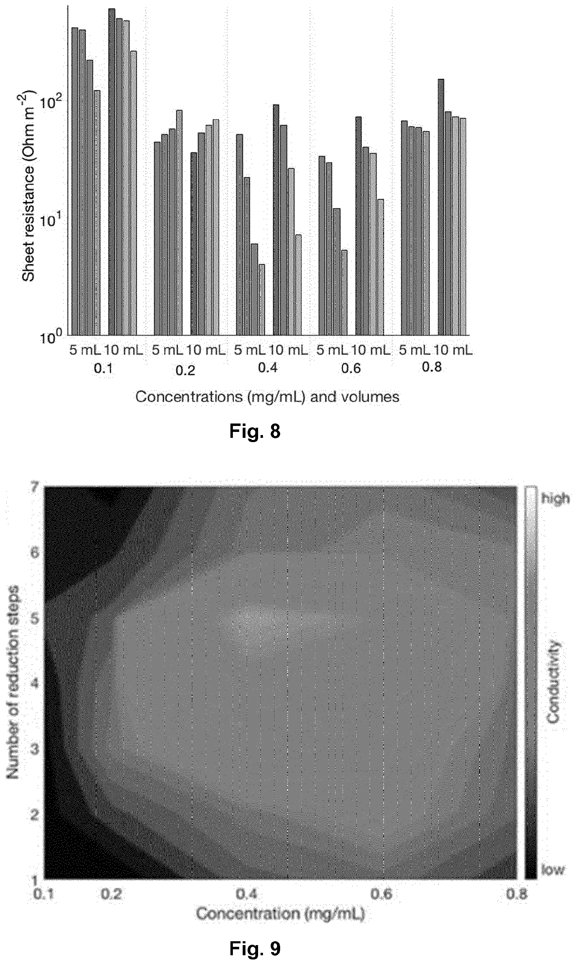

Using a four-point-probe method, an in-depth electrical analysis was performed in order to follow the evolution of the conductive behavior of the material while varying the concentration of GO (in both 5 and 10 mL aqueous suspensions) and the degree of reduction (from two to five times reduced) (Fig. 8). For each concentration the lower volumes allowed to reach lower resistances.

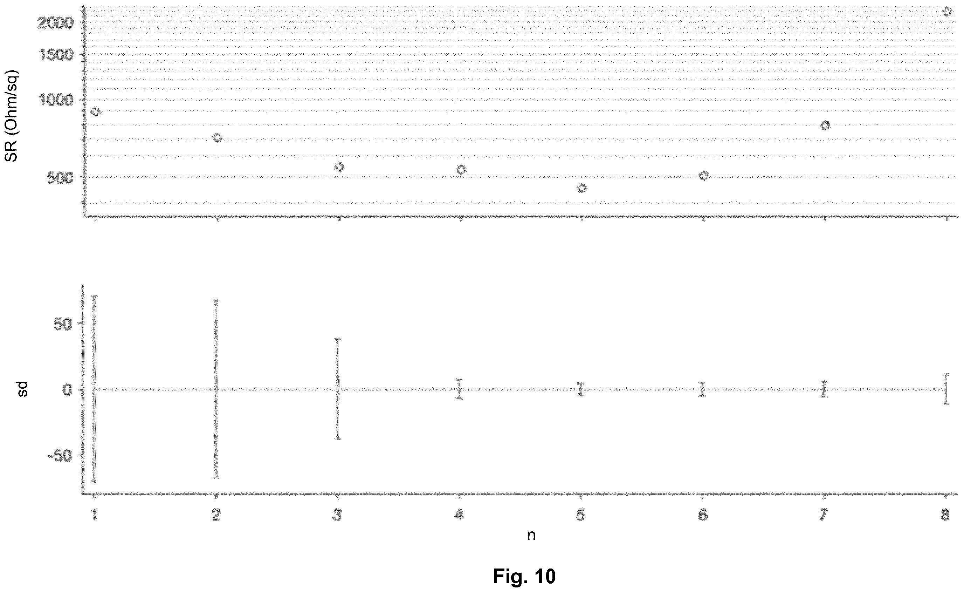

The contour map (Fig. 9) shows the conductivity trend for different concentration of GO in a 5 mL aqueous suspension as the number of reduction steps increases. For concentrations lower than 0.1 mg/mL it was not possible to obtain good results since the reduction process was too aggressive for the thin surface, which was immediately damaged, resulting in a non-conductive material. On the contrary, for concentrations higher than 0.8 mg/mL the rGO layer transferred was too thick and the conductivity was very low. Thus, it was concluded that for concentrations between 0.3 and 0.7 mg/mL, the conductivity of the material increased with the number of reduction steps until the degree of reduction reached a threshold value. Indeed, too many reductions degraded the material and after the transfer the inner and less reduced layers emerged, resulting in a low conductivity of the rGO film. The best and most stable result was obtained for concentrations around 0.4 mg/mL five times reduced. As can be seen in Fig. 10, the standard deviation decreases as the number of reduction steps increases, while the sheet resistance decreases until five reduction steps, whereupon strongly rises up.

According to these results, GO from an initial aqueous suspension of 0.4 mg/mL in 5 mL and then five times reduced was chosen as the preferential combination for further analysis and applications.

### Reduction degree

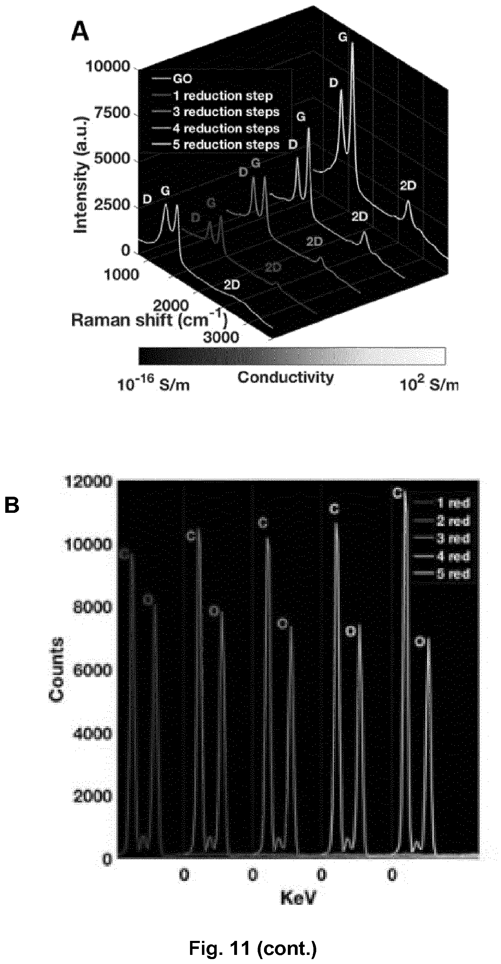

The reduction degree of the surface for different reduction steps, from GO to rGO five times reduced, was studied using Raman spectroscopy, X-ray photoelectron spectroscopy (XPS) and energy-dispersive X-ray spectroscopy (EDX). Raman spectra of rGO (Fig. 11A) exhibited the characteristic G band at 1580 cm⁻¹ and D band at 1350 cm⁻¹. The I_{D}/I_{G} ratio, which is an index of the disorder in graphenic materials, decreased as the number of reduction steps increased. This may be due to both the removal of the oxygen-functional groups and to the restoration of sp² domain. The strong increase in the 2D band intensity further supported this behavior. EDX analysis (Fig. 11B) confirmed that as the number of reduction steps increased, the number of carbons on the surface rises, while the number of oxygens went down. The C/O atomic ratio increased from 1.09% after one reduction to 1.6% after five reduction steps, as shown in Table 2 below.

**Table 2 Table of element from EDX analysis.**

| Reduction degree | Weight % C K | Atomic % C K | Weight % O K | Atomic % O K |
|---|---|---|---|---|
| 1 reduction step | 41.40 | 47.98 | 50.83 | 43.84 |
| 2 reduction steps | 42.76 | 49.40 | 49.51 | 42.94 |
| 3 reduction steps | 44.57 | 51.28 | 48.52 | 41.90 |
| 4 reduction steps | 44.23 | 50.80 | 46.55 | 40.13 |
| 5 reduction steps | 53.49 | 60.51 | 46.51 | 39.49 |

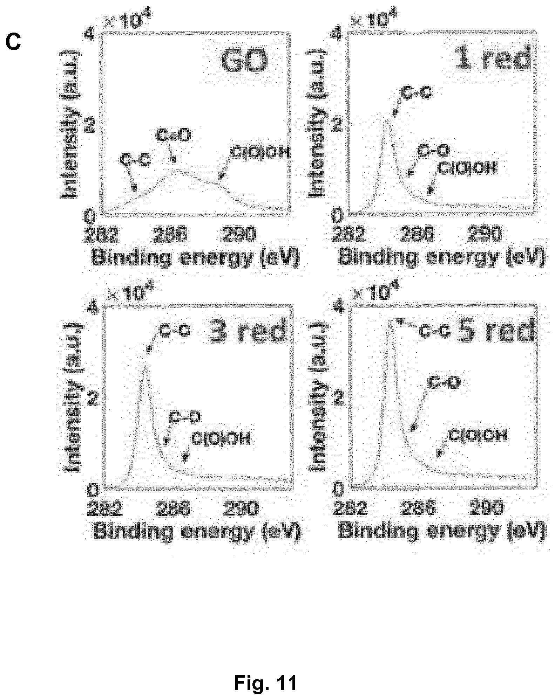

XPS analysis (Fig. 11C) confirmed the removal of the oxygen-containing groups, as well as the increasing of C-C bonds with the number of reduction steps. The C 1s spectrum of GO shows the typical C-C, C=O and C(O)OH bonds at 284.1, 286.4, and 288.7 eV, respectively; while the rGO spectra show a strong increase in C-C bond intensity and a decrease in both C=O and C-O intensities confirming the de-oxygenation of the surface after the reduction, which is further supported by the new presence of a C-O bond around 285 eV. The weak shift in the peak intensities between GO and rGO may be due to the changing in the environment after the reduction.

### Bending test

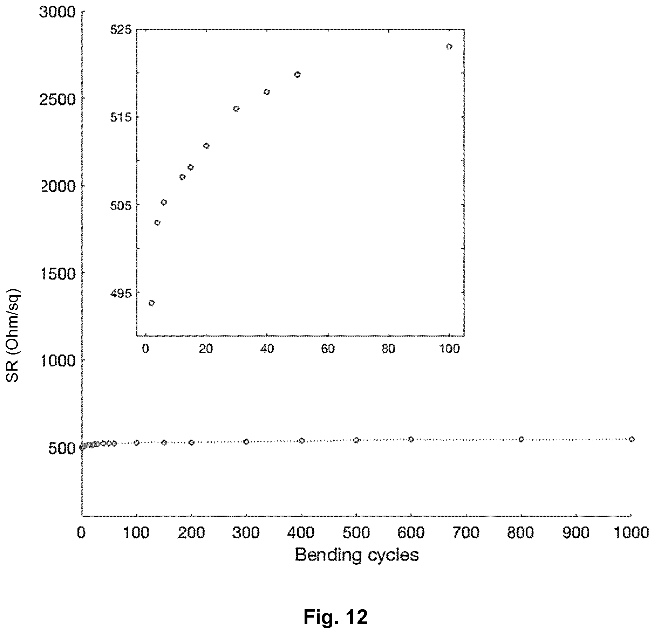

Since it is desirable to exploit the transfer capabilities and the good electrical properties of the material for wearable applications and paper-based devices on flexible substrates, the stability of the material under tensile stress performing a bending test (Fig. 12) was verified. As evidenced, after 1000 cycles the sheet resistance changed by 50 Ω, i.e., less than 10% compared to the initial one.

The bending test revealed a high stability in the electrical resistance under a physical stress. The zoomed area in the insert shows that in the first 100 cycles there is the major changes in the resistance, accordingly to the fact that nitrocellulose paper, used as substrates, may reach its yield point after 100 bending cycles, and then stabilize its structure.

### Example 4

As a proof of good conductivity of the material and the possible uses of its transferability, an electroluminescent lamp was produced using patterned rGO as rear electrode. The word "NANO" was laser-scribed and transferred to the display replacing the commonly used silver ink. The light produced by the panel could be observed only in the area where the transferred rGO was present, demonstrating its capabilities as an alternative to the expensive silver inks.

### Example 5. 3D Circuitry

The transfer of multiples lines, overlaid and with dielectric or capacitive paste in between, was done, what could open the way for easy-to-manufacture 3D circuitry. For the first line the sheet resistance is R₁ = 560 Ω m⁻², the sheet resistance between the first line and second line, and the second and the third ones is R² = 570 Ω m⁻², between the first and the third ones R₃ = 590 Ω m⁻², proving that the contact resistance is very low. Using dielectric ink, the lines were completely isolated from each other exhibiting a capacitance of C= 7 pF.

As an example of the above mentioned, four rGO conductive lines on fabric (one on top of each other) separated by a wax printed dielectric were transferred, one for each LED using a common negative. The lines were connected with copper tape to an Arduino board and to three LEDs, red, green and. By using a known library named CapacitiveSensor and an Arduino sketch, the device can be used as a proximity and touch sensor establishing certain threshold values. The sensor was made of rGO transferred on PET; when the finger was approaching, the LEDs light up starting from the blue to the green one and when the sensor was touched the red LED turned on.

### Example 6. Stability and sensitivity of the rGO electrodes

Since a goal of the invention is its application on paper and textiles, the hydrophobicity of the material was confirmed by measuring the contact angle values on different substrates.

Nitrocellulose electrodes were stable in terms of time, since they could last hours in solution before the graphene become dissolved. Moreover, the electrodes themselves turned out to be very resistant proving to be an excellent substrate for electrochemical applications that require long measurement times or functionalization in aqueous solvents.

### Example 7. Electrochemical characterization

Electrochemical characterization of the rGO electrodes was performed in the presence of an outer sphere redox probe [Ru(NH₃)₆]Cl₃. This definition refers to the mechanism involved between the electrode (a carbonaceous material) and the redox probe present in solution, particularly to a molecule that interacts only with the electronic density of state of the electrode, which is not sensitive to the electrode surface structure. Promising results were obtained in terms of electrocatalysis and electroactivity, especially when they were compared with the standard carbon-based screen-printed electrodes (C-SPEs).

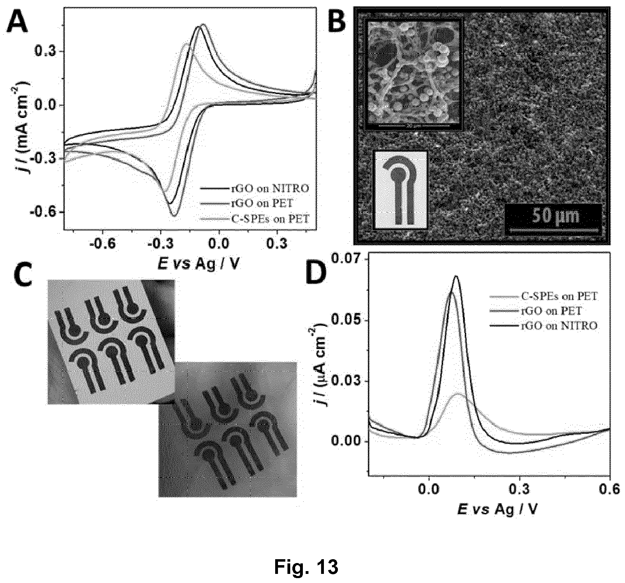

Fig. 13 shows the voltammograms of the rGO based electrodes on nitrocellulose paper, PET and C-SPEs obtained at 50 mV s⁻¹ in presence of 3 mM of [Ru(NH₃)₆]Cl₃. Dealing with the outer sphere redox probe, we can compare the electrochemical response of the electrodes, which is not influenced by the fact that they are made of different materials. It can be noticed, looking at the cathodic peak, that with the rGO based electrodes there is an electrocatalysis effect (peak position at potential closer to zero) and electroactivity (higher density current values) in comparison with the C-SPEs. The values of the current were normalized for the geometric area of the electrode, which is the same for the three electrodes (0.07065 cm²). All parameters extrapolated from the electrochemical characterization are reported in Table 3, which is a summary of the calculated parameters from the electrochemical characterization of all the devices.

**Tabla 3**

| Electrode | RGO on PET | RGO on NITRO | C-SPE |
|---|---|---|---|
| log(i_{c}) vs log(v) | (0.460 ± 0.004) | (0.46 ± 0.02) | (0.46 ± 0.01) |
| ΔEₚₚ | (121 - 312) mV | (101 - 342) mV | (96 - 222) mV |
| (Eₚ - Ep_{1/2})_{c} | (70 - 138) mV | (67 - 146) mV | (65 - 101) mV |

From the slope of the curve log(i_{c}) *vs* log(*v*), where i*_{c}* means cathodic current intensity, values not so far from the α = 0.5, indicative of a perfect linear diffusive behavior, were obtained. Regarding the distance between the anodic and cathodic peaks (ΔEₚₚ), in all cases an electrochemical irreversible behavior is observed, because the distance increases as the scan rate increases and it is not equal to 57 mV. In more detail, the first value refers to the slowest scan and the last value to the fastest. In the same way, the difference between the cathodic peak position and the peak position at half height (Eₚ - Ep_{1/2})_{c} increases as the scan rate increases, confirming the electrochemical irreversible behavior. A SEM image of the rGO electrode on nitrocellulose and pictures of the transferred electrodes are shown in Fig. 13B and Fig. 13C respectively.

### Example 8. Application as electroanalytical sensors

A preliminary test of the application of these electrodes as sensors for the detection of dopamine (used as a model) was investigated. The electrodes were tested in a solution of 10⁻⁴ M of dopamine in PBS and their performances were compared with the standard C-SPEs. The electroanalytical results are shown in Fig. 13D, where it is clearly visible the higher signals obtained when using the graphene based electrodes instead of the C-SPEs. The density current values (normalized, as before, for the geometric area of the three devices) are four times higher using the rGO electrodes. The results obtained allowed to assert that these rGO devices can be applied in paper-based and flexible nanoelectronics, and as electroanalytical sensors.

### Citation List

1. WO2015193486A1;
2. WO2012128748;
3. V. Strong, et al. "Patterning and Electronic Tuning of Laser Scribed Graphene for Flexible All-Carbon Devices", ACS Nano, 2012, Vol. 6, pp. 1395-1403.

## Claims

1. A method of forming an electronic device on a substrate, the method comprising the steps of:
a) filtering a graphene oxide (GO) aqueous suspension through a porous membrane in order to obtain a GO film,
b) laser scribing a specific design on the GO film in order to form a reduced graphene oxide (rGO) pattern on the GO film;
c) pressing the substrate against the rGO pattern on the GO film in order to transfer the rGO pattern to the substrate to form the electronic device thereon.

2. The method of claim 1, wherein the porous membrane is made of nitrocellulose having a pore size from 0.01 µm to 0.3 µm.

3. The method of claims 1 or 2, wherein the amount of GO per unit area is from 0.04 mg/cm² to 0.32 mg/cm², particularly from 0.12 mg/cm² to 0.28 mg/cm², more particularly of 0.16 mg/cm².

4. The method of any one of claims 1 to 3, wherein laser scribing is performed until the rGO has a carbon content from 75% to 96.5% and an oxygen content from 25% to 3.5%.

5. The method of any one of claims 1 to 4, wherein the transfer step is performed with a press that exerts a pressure from 0.4 kg/cm² to 300 kg/cm², particularly of 230 kg/cm².

6. The method of any one of claims 1 to 5, wherein the transferred rGO pattern has a from 30 nm to 1000 nm, particularly from 40 nm to 600 nm.

7. The method of any one of claims 1 to 6, wherein the transferred rGO pattern has a resistivity from 100 Ω/sq to 2000 Ω/sq at room temperature.

8. The method of any one of claims 1 to 7, wherein the substrate is a flexible substrate.

9. The method of any one of claims 1 to 8, wherein the flexible substrate is selected from the group consisting of (ITO), aluminum foil, polydimethylsiloxane (PDMS), poly(ethylene terephthalate) (PET); paper; skin; diverse types of textile.

10. The method of any one of claims 1 to 9, wherein steps a), b) and c) are repeated in order to form at least two overlaid lines of rGO.

11. The method of claim 10, wherein a layer of dielectric paste or of capacitive is applied between each two consecutive lines of rGO.

12. An electronic device on a substrate obtainable by the method as defined in any one of claims 1 to 11.

13. The electronic device on a substrate of claim 12 which is an electroanalytical sensor, a proximity and touch sensor, or an electronic tattoo sensor on the skin.

14. The electronic device on a substrate of claim 13 which is an electrochemical lateral flow sensor.

15. An apparatus comprising an electronic device on a substrate as defined in claims 12 to 14.
